# EUROPEAN PATENT SPECIFICATION

(11) **EP 4 604 695 B1**
(45) Date of publication and mention of the grant of the patent: **04.11.2026**
(21) Application number: 25187311.3
(22) Date of filing: 03.02.2023
(51) Int. Cl.: H10F 10/165, H10F 10/166, H10F 77/14, H10F 77/20, H10F 77/30

(54) **SOLAR CELL AND PHOTOVOLTAIC MODULE**
SOLARZELLE UND FOTOVOLTAISCHES MODUL
CELLULE SOLAIRE ET MODULE PHOTOVOLTAÏQUE

(30) Priority: 27.06.2022 CN 202210745275
(43) Date of publication of application: 20.08.2025
(60) Divisional application: 26205984.3 / 4 836 643
(62) Document number(s) of the earlier application(s) in accordance with Art. 76 EPC: 23154994.0 / 4 300 599
(73) Proprietor: Zhejiang Jinko Solar Co., Ltd., Haining, Zhejiang 314416 (CN); JINKO SOLAR CO., LTD, ShangRao, Jiangxi 334100 (CN)
(72) Inventor: ZHANG, Bike, HAINING, ZHEJIANG, 314416 (CN); JIN, Jingsheng, HAINING, ZHEJIANG, 314416 (CN); ZHANG, Xinyu, HAINING, ZHEJIANG, 314416 (CN); CAO, Jingyu, HAINING, ZHEJIANG, 314416 (CN); CHENG, Haiyan, HAINING, ZHEJIANG, 314416 (CN)
(74) Representative: Balder IP Law, S.L.

(56) References cited:
- EP-A1- 4 002 493
- CN-A- 108 666 393
- CN-A- 110 690 297
- CN-A- 112 349 798
- CN-U- 210 897 294
- KR-A- 20160 097 926

## Description

### TECHNICAL FIELD

Embodiments of the present disclosure relate to the photovoltaic field, and in particular to a solar cell and a photovoltaic module.

### BACKGROUND

With the increasing shortage of energy, the development and utilization of renewable energy is extremely urgent. Among the numerous renewable energy sources, solar energy has outstanding advantages such as no depletion risk, safety and reliability, no noise, no pollution emissions, and no limitation on distribution region of resources to its application.

Solar cells are used to convert solar energy into electrical energy, thus solar cells have been widely used. Solar cells may be classified into crystalline silicon cells and thin film cells. Among crystalline silicon cells, cells with a passivation contact structure of at least one tunneling oxide layer are widely favored because of their higher theoretical efficiency. Therefore, it is necessary to study cells with a passivation contact structure of at least one tunneling oxide layer which have better performance.

EP 4002493A1 provides a solar cell comprising a substrate, an interface passivation layer covering the rear surface of the substrate (including a first interface passivation sub-layer between adjacent electrodes and a second interface passivation sub-layer between the substrate and the electrode).

CN 112349798A provides a solar cell and its manufacturing method. The solar cell includes a substrate, an emitter on the upper surface of the substrate, and a tunneling layer, a field passivation layer, a second passivation film, and a second electrode sequentially stacked on the lower surface.

CN 210897294U provides a solar cell including a semiconductor substrate, a metal electrode, and a tunneling layer and a doped polysilicon layer sequentially stacked on one side surface of the semiconductor substrate.

CN 110690297A provides a P-type tunnel oxide passivated contact solar cell and its preparation method. The solar cell includes P-type silicon, with an N-type heavily doped silicon layer and a front SiNx anti-reflection layer sequentially deposited on the front surface from the inside out.

CN 108666393A provides a method for preparing a solar cell and the corresponding solar cell. The method involves: after texturing and back polishing the substrate, preparing a first tunneling oxide layer on the front surface and a second tunneling oxide layer on the back surface; growing a first polysilicon layer on the area of the first tunneling oxide layer corresponding to the front gate line, a second polysilicon layer on the second tunneling oxide layer, a front field on the front surface, and an emitter on the back surface of the substrate; growing a first anti-reflection film on the front surface and a second anti-reflection film on the back surface after preparing the front field and emitter; printing front and back gate lines on the corresponding surfaces and performing sintering.

KR 20160097926A provides a high-efficiency solar cell including a semiconductor substrate, a first conductivity-type region partially disposed on the front surface of the semiconductor substrate, a second conductivity-type region disposed on the rear surface, a first electrode connected to the first conductivity-type region, and a second electrode connected to the second conductivity-type region.

### SUMMARY

Embodiments of the present disclosure provide a solar cell and a photovoltaic module, which are at least conducive to improving performance of cells with a passivation contact structure of at least one tunneling oxide layer. The invention is set out in the appended set of claims.

Some embodiments of the present disclosure provide a solar cell including a substrate, a passivation contact structure, silicon connection structures, an antireflection layer, and a plurality of finger electrodes. The substrate includes a first surface and a second surface. The passivation contact structure is formed on the first surface of the substrate and includes a tunneling dielectric layer formed on the first surface, and a doped silicon layer formed on the tunneling dielectric layer. The first doped conductive layer has a plurality of protrusions arranged along a first direction, each protrusion of the plurality of protrusions extends along a second direction perpendicular to the first direction. The first conductive connection structures are formed at intervals along the second direction and each extending along the first direction. At least one silicon connection structure of the silicon connection structures is formed between two respective adjacent protrusions of the plurality of protrusions and is connected with sidewalls of the two respective protrusions. The antireflection layer is formed over the first doped conductive layer and the silicon connection structures. Each finger electrode of the plurality of finger electrodes extends along the second direction and penetrate the antireflection layer to connect to a respective protrusion.

In some embodiments, a material of the antireflection layer includes one or more of hydrogen-containing silicon oxide, hydrogen-containing silicon nitride, and hydrogen-containing silicon oxynitride.

In some embodiments, the silicon connection structures form an array.

In some embodiments, in a direction perpendicular to the first surface of the substrate, a ratio of a height of one respective silicon connection structure of the silicon connection structures to a height of one respective protrusion of the plurality of protrusions ranges from 0.5 to 1.2.

In some embodiments, there is at least one finger electrode located between adjacent silicon connection structures in the first direction.

In some embodiments, the array includes a plurality of columns of silicon connection structures arranged along the first direction and a plurality of rows of silicon connection structures arranged along the second direction.

In some embodiments, along the first direction, silicon connection structures forming one respective column of the plurality of columns of silicon connection structures are unaligned with silicon connection structures forming another column of the plurality of columns of silicon connection structures adjacent to the one respective column; and along the second direction, silicon connection structures forming one respective row of the plurality of rows of silicon connection structures are unaligned with silicon connection structures forming another row of the plurality of rows of silicon connection structures adjacent to the one respective row.

In some embodiments, the solar cell further includes at least one busbar extending along the first direction and electrically connected with the plurality of finger electrodes arranged along the first direction.

In some embodiments, projections of the silicon connection structures on the substrate are at least partially overlapped with a projection of the at least one busbar on the substrate.

In some embodiments, in a direction perpendicular to the first surface of the substrate, top surfaces of the silicon connection structures are lower than or flush with a top surface of one respective protrusion of the plurality of protrusions.

In some embodiments, the plurality of silicon connection structures and the doped silicon layer are made of a same material, and the doped silicon layer and the substrate are of different doping types.

In some embodiments, the solar cell further includes a second passivation contact structure formed on the second surface of the substrate, second silicon connection structures, a second antireflection layer, and a plurality of second finger electrodes. The second passivation contact structure includes a second tunneling dielectric layer formed on the second surface, and a second doped silicon layer formed on the second tunneling dielectric layer. The second doped silicon layer has a plurality of second protrusions arranged along the first direction, and each second protrusion of the plurality of second protrusions extends along the second direction. The second silicon connection structures are formed at intervals along the second direction and each extending along the first direction. At least one second silicon connection structure of the second silicon connection structures is formed between two respective adjacent second protrusions of the plurality of second protrusions and is connected with sidewalls of the two respective second protrusions. The second antireflection layer is formed over the second doped silicon layer and the second silicon connection structures. Each second finger electrode of the plurality of second finger electrodes extends along the second direction and penetrate the second antireflection layer to connect to a respective second protrusion.

In some embodiments, the second doped silicon layer and the substrate are of a same doping type.

Some embodiments of the present disclosure provide a photovoltaic module, including: at least one cell string including a plurality of solar cells as described above, the plurality of solar cells are electrically connected; at least one encapsulation layer configured to cover a surface of the at least one cell string; and at least one cover plate configured to cover a surface of the at least one encapsulation layer facing away from the at least one cell string.

In some embodiments, the at least one cover plate has a light trapping structure.

### BRIEF DESCRIPTION OF THE DRAWINGS

One or more embodiments are exemplarily illustrated in reference to corresponding accompanying drawing(s), and these exemplary illustrations do not constitute limitations on the embodiments. Unless otherwise stated, the accompanying drawings do not constitute scale limitations. In order to more clearly illustrate the embodiments of the present disclosure or the technical solutions in the existing technology, the following will briefly describe the drawings used in the embodiments. Obviously, the drawings in the following description are only some embodiments of the present disclosure. Those skilled in the art can also obtain other drawings based on these drawings without any inventive work.
FIG. 1 is a structural schematic diagram of a solar cell according to some embodiments of the present disclosure.
FIG. 2 is a sectional schematic diagram of the solar cell according to some embodiments of the present disclosure.
FIG. 3 is a top view of a first solar cell according to some embodiments of the present disclosure.
FIG. 4 is a top view of a second solar cell not part of the invention according to some embodiments of the present disclosure.
FIG. 5 is a top view of a third solar cell according to some embodiments of the present disclosure.
FIG. 6 is a top view of a fourth solar cell according to some embodiments of the present disclosure.
FIG. 7 is a top view of a fifth solar cell according to some embodiments of the present disclosure.
FIG. 8 is a structural schematic diagram of a photovoltaic module according to some embodiments of the present disclosure.

### DETAILED DESCRIPTION OF THE EMBODIMENTS

It can be known from the background art that parasitic absorption of light of the existing doped conductive layer may reduce utilization rate of light of solar cells. Generally, a thickness of the doped conductive layer is reduced to address the parasitic absorption of light of the doped conductive layer. To this end, a structure of the doped conductive layer having protrusions is proposed. A relatively thick doped conductive layer is formed in a region in which the finger electrodes are formed, and a relatively thin doped conductive layer is formed in a region between adjacent finger electrodes. In this way, the parasitic absorption of light of the doped conductive layer can be reduced. However, this structure introduces new problems. For example, due to the narrow transverse transferring channel resulted from the relatively thin doped conductive layer formed in the region between adjacent finger electrodes, a large number of carriers collide and consume each other in the transferring process, thereby affecting the transferring rate of carriers

In the embodiments of the present disclosure, at least one conductive connection structure is formed between and connected with adjacent protrusions. In this way, the carriers can be transferred through the at least one conductive connection structure in the transverse transferring process, thereby improving the transverse transferring capacity of the carriers and the doped conductive layer. Moreover, compared with the relatively thick doped conductive layer, the solar cell provided by the present disclosure can reduce parasitic absorption of light of the doped conductive layer.

Embodiments of the present disclosure will be described in detail below with reference to the accompanying drawings. Those skilled in the art should understand that, in the embodiments of the present disclosure, many technical details are provided for the reader to better understand the present disclosure. However, even without these technical details and various modifications and variants based on the following embodiments, the technical solutions claimed in the present disclosure can be realized.

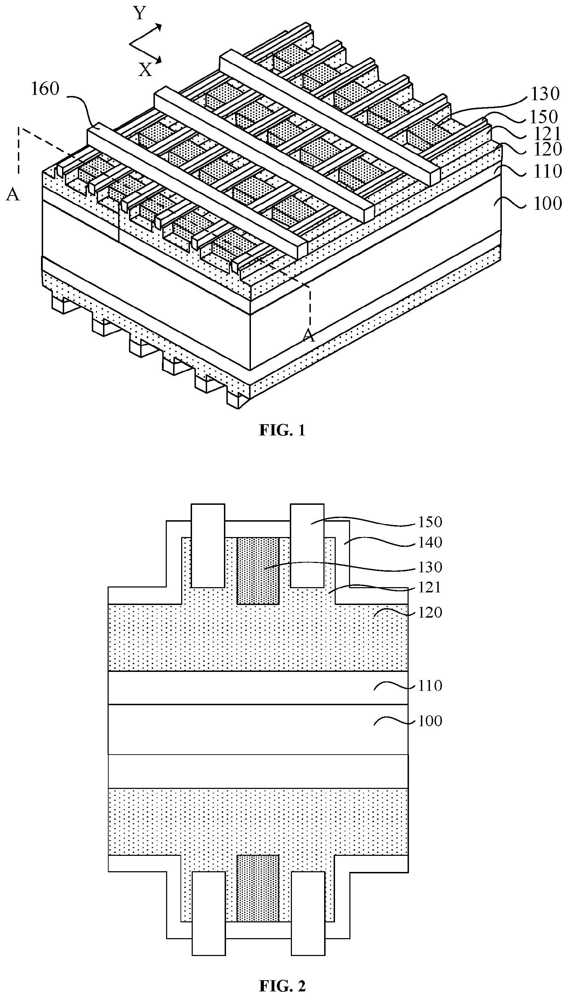

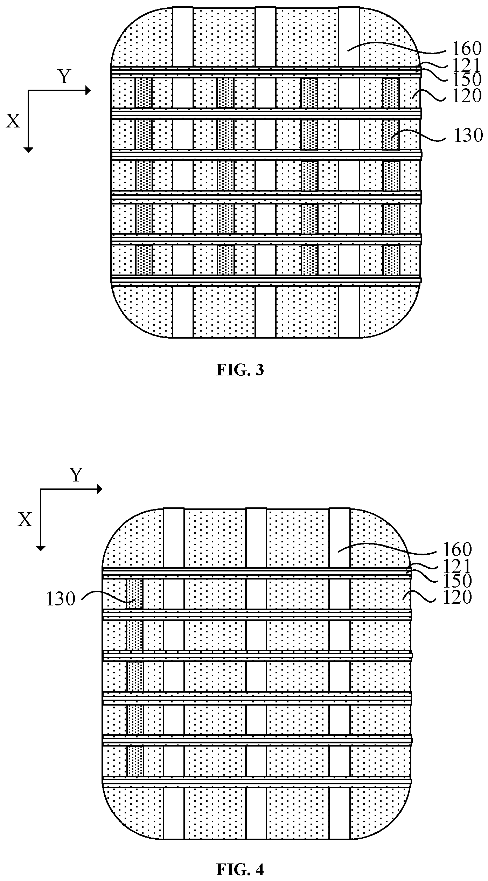

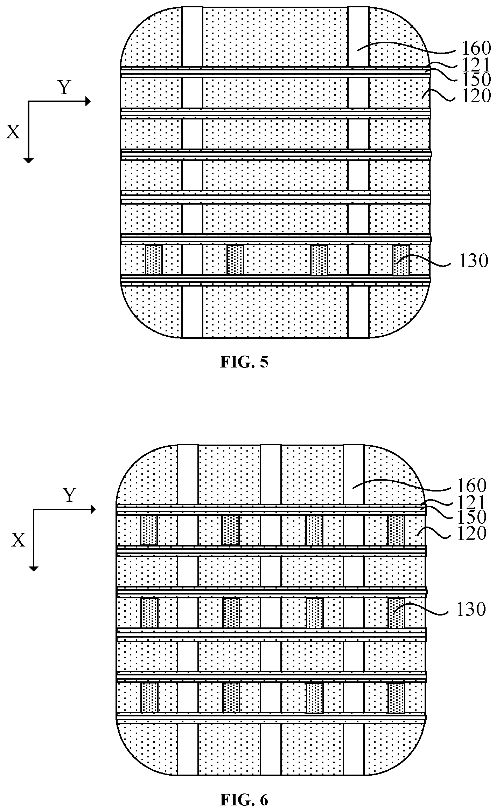

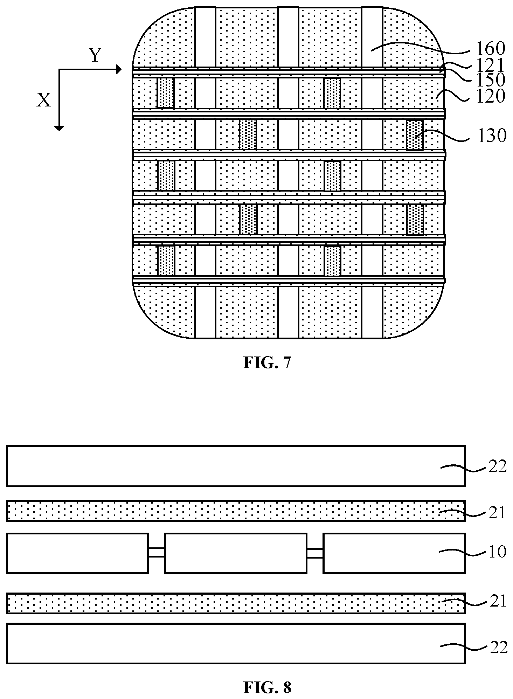

FIGS. 1 to 7 are structural schematic diagrams of the solar cell provided by embodiments of the present disclosure. FIG. 1 is a structural schematic diagram of a solar cell provided by some embodiments of the present disclosure. FIG. 2 is a sectional schematic diagram along the dotted line AA in FIG. 1 of the solar cell provided by some embodiments of the present disclosure. FIG. 3 is a top view of a first solar cell provided by some embodiments of the present disclosure. FIG. 4 is a top view of a second solar cell not part of the invention provided by some embodiments of the present disclosure. FIG. 5 is a top view of a third solar cell provided by some embodiments of the present disclosure. FIG. 6 is a top view of a fourth solar cell provided by some embodiments of the present disclosure. FIG. 7 is a top view of a fifth solar cell provided by some embodiments of the present disclosure.

Referring to FIGS. 1 to 7, the solar cell includes a substrate 100, a tunneling dielectric layer 110, a doped conductive layer 120, at least one conductive connection structure 130, a passivation layer 140 and a plurality of finger electrodes 150. The tunneling dielectric layer 110 is formed on the substrate 100. The doped conductive layer 120 is formed on the tunneling dielectric layer 110 and has a plurality of protrusions 121 arranged along a first direction X, each protrusion 121 of the plurality of protrusions 121 extends along a second direction Y perpendicular to the first direction X. The at least one conductive connection structure 130 is formed between two adjacent protrusions 121 and is connected with sidewalls of the two adjacent protrusions 121. The passivation layer 140 is over the doped conductive layer 120 and the at least one conductive connection structure 130. Each finger electrode 150 of the plurality of finger electrodes 150 extends along the second direction Y to penetrate the passivation layer 140 and connect to a respective protrusion 121. By forming the at least one conductive connection structure 130, carriers can be transversely transferred through the at least one conductive connection structure 130 between two adjacent protrusions 121. In this way, transverse transferring capacity of the solar cell can be improved.

In some embodiments, the substrate 100 is a silicon substrate, which may include one or more of monocrystalline silicon, polycrystalline silicon, amorphous silicon or microcrystalline silicon. In some other embodiments, the material of the substrate 100 may include silicon carbide, organic material or multicomponent compound. The multicomponent compound may include, but is not limited to, perovskite, gallium arsenide, cadmium telluride, copper indium selenium and the like.

In some embodiments, the substrate 100 has N-type or P-type doping elements. N-type elements may be Group-V elements such as phosphorus (P), bismuth (Bi), antimony (Sb) or arsenic (As), and P-type elements may be Group-III elements such as boron (B), aluminum (Al), gallium (Ga) or indium (In). For example, when the substrate 100 is a P-type substrate, the doping elements in the substrate are P-type elements. Alternatively, when the substrate 100 is an N-type substrate, the doping elements in the substrate are N-type elements.

In some embodiments, the tunneling dielectric layer 110 and the doped conductive layer 120 may form a passivation contact structure on the substrate 100. The formation of the tunneling dielectric layer 110 and the doped conductive layer 120 can reduce the recombination of carriers at surface of the solar cell and increase the open-circuit voltage of the solar cell, thereby improving the efficiency of the solar cell. In some embodiments, the tunneling dielectric layer 110 may be formed on a first surface of the substrate 100. The first surface is a light receiving surface facing sunlight. In some embodiments, the tunneling dielectric layer 110 may be formed on a second surface of the substrate 100. The second surface is a surface opposite to the first surface and facing away sunlight. In some embodiments, the tunneling dielectric layer 110 may be formed on both the first surface and the second surface of the substrate 100 (not shown in FIG. 1). It should be understood that other layers on the tunneling dielectric layer 110 are also formed on the first surface and/or the second surface of the substrate 100 at the same time.

In some embodiments, the tunneling dielectric layer 110 may be further configured to reduce or prevent the diffusion of doping elements in the doped conductive layer 120 into the substrate 100.

In some embodiments, the materials of the tunneling dielectric layer 110 may include, but are not limited to, dielectric materials having tunneling effect such as aluminum oxide, silicon oxide, silicon nitride, silicon oxynitride, intrinsic amorphous silicon, intrinsic polycrystalline silicon and the like. The tunneling dielectric layer 110 may be formed by a layer of oxide of silicon (SiOx), which has good passivation characteristics, and carriers can easily tunnel through the layer of oxide of silicon.

In some embodiments, a thickness of the tunneling dielectric layer 110 may range from 0.5 nm to 2.5 nm. In some other embodiments, the thickness of the tunneling dielectric layer 110 ranges from 0.5 nm to 2 nm. In some other embodiments, the thickness of the tunneling dielectric layer 110 ranges from 0.5 nm to 1.2 nm. When the thickness of the tunneling dielectric layer 110 is less than 0.5 mm, it is difficult to form the tunneling dielectric layer 110. When the thickness of the tunneling dielectric layer 110 is greater than 2.5 mm, the tunneling effect is weak.

In some embodiments, the at least one conductive connection structure 130 and the doped conductive layer 120 are made of a same material. In this way, the variety of materials in the production process can be reduced to facilitate management. For example, the materials of the conductive connection structure 130 include at least one of polycrystalline silicon, amorphous silicon or microcrystalline silicon.

In some embodiments, the protrusions 121 of the doped conductive layer 120 and the at least one conductive connection structure 130 may be formed at the same time. In other words, the protrusions 121 and the at least one conductive connection structure 130 are formed by etching the doped conductive layer 120 in a same process operation. In this way, the connection reliability between the protrusions 121 and the at least one conductive connection structure 130 can be secured, and the number of production operations in the generating process and production time can be reduced. In some other embodiments, the protrusions and the at least one conductive connection structure may be formed separately.

In some embodiments, the material of the doped conductive layer 120 may be one of doped amorphous silicon, doped polycrystalline silicon or doped microcrystalline silicon. In some other embodiments, the doped conductive layer 120 may be made of other materials, such as silicon carbide, which may be selected according to actual situation.

In some embodiments, a conductive layer may be first formed on the tunneling dielectric layer 110, and then dope the conductive layer to form the doped conductive layer 120.

In some embodiments, the thickness of the doped conductive layer 120 ranges from 40 nm to 150 nm. In some other embodiments, the thickness of the doped conductive layer 120 ranges from 60 nm to 90 nm. The above-mentioned ranges of thickness of the doped conductive layer 120 can ensure that the optical loss of the doped conductive layer 120 is low and the interface passivation effect of the tunneling dielectric layer 110 is good, thereby improving the efficiency of the solar cell. In the embodiments of the present disclosure, the material of the doped conductive layer may be polycrystalline silicon.

In some embodiments, the doped conductive layer 120 and the substrate 100 are of a same doping type. It can be understood that when the doping type of the substrate 100 is N type and the doping type of the doped conductive layer 120 is P type, the majority carriers in the substrate 100 are electrons and the majority carriers in the doped conductive layer 120 are holes, recombination will occur between the electrons and the holes, resulting in reduction of the carriers collected by the finger electrodes 150. Therefore, when the doped conductive layer 120 and the substrate 100 are of a same doping type, reduction of the carriers collected by the finger electrodes 150 can be prevented.

In some embodiments, the substrate 100 is an N-type substrate, and the doped conductive layer 120 is an N-type polycrystalline silicon layer. In some other embodiments, the substrate is a P-type substrate, and the doped conductive layer is a P-type polycrystalline silicon layer. The N-type substrate and N-type polycrystalline silicon layer have relatively high photoelectric conversion efficiency. The formation process of the P-type substrate and P-type polycrystalline silicon layer is simple and can be selected according to the actual situation. The embodiments of the present disclosure do not limit the substrate 100 and the doped conductive layer 120.

In some embodiments, the conductive connection structure 130 and the protrusions 121 are formed by etching the doped conductive layer 120. The shape of the doped conductive layer 120 may be set first, and then the doped conductive layer 120 is etched to form the protrusions 121 and the conductive connection structure 130 in a same process operation.

In some embodiments, the passivation layer 140 may be an antireflection film layer. In this way, the light reflected by the surface of the solar cell can be reduced, thereby increasing the light transmittance of the solar cell. The passivation layer 140 may have a single-layer structure or a stacked-layers structure, and the materials of the passivation layer 140 may include one or more of silicon oxide, silicon nitride, silicon oxynitride, silicon oxycarbonitride, titanium oxide, hafnium oxide, aluminum oxide or the like. In some embodiments, the passivation layer 140 is a hydrogen containing passivation layer, for example, the passivation layer is made of silicon oxide containing hydrogen, silicon nitride containing hydrogen, silicon oxynitride containing hydrogen and the like.

In some embodiments, the plurality of finger electrodes 150 is used to collect and converge the currents of the solar cell. The finger electrodes 150 may be obtained by sintering firing-through paste. The materials of the finger electrodes 150 may include one or more of aluminum, silver, gold, nickel, molybdenum or copper. In some embodiments, the finger electrodes 150 refer to thin grid lines or finger grid lines, which are different from the main grid lines or busbars.

Referring to FIGS. 3 to 7, in some embodiments, the solar cell includes a plurality of conductive connection structures 130 arranged at intervals along at least one of the first direction X and the second direction Y, and there is at least one finger electrode 150 between adjacent conductive connection structures 130 in the first direction X. In other words, the plurality of conductive connection structures 130 may be arranged at intervals along the first direction X, the second direction Y or the first direction X and the second direction Y. In the first direction X, there is at least one finger electrode 150 between adjacent conductive connection structures 130. When there is one finger electrode 150 between adjacent conductive connection structures 130, there is one or more conductive connection structures 130 between every two adjacent protrusions. When there are a plurality of finger electrodes 150 between adjacent conductive connection structures 130, the conductive connection structures 130 may be distributed in a spaced manner. For example, in the first direction, there is one or more conductive connection structures 130 between a first and a second finger electrodes, but there is no conductive connection structure 130 between the second and a third finger electrodes. By forming at least one finger electrode 150 between adjacent conductive connection structures 130, the transverse transferring capacity of the solar cell can be improved.

It is noted that the above-mentioned finger electrode, second finger electrode and third finger electrode are only used to illustrate, and do not constitute a limit to the finger electrodes 150.

Referring to FIGS. 3 and 4, in some embodiments, there is at least one conductive connection structure 130 between each two adjacent finger electrodes 150. In other words, there is at least one conductive connection structure 130 between all finger electrodes 150 that are adjacent. In this way, the transverse transferring capacity between adjacent protrusions 121 can be improved.

Referring to FIG. 6, in some embodiments, there is at least one conductive connection structure 130 between some of the adjacent finger electrodes 150, there is no conductive connection structure 130 between some of the adjacent finger electrodes 150, and in the first direction, the conductive connection structures 130 may be arranged in a regular manner. For example, there is one or more conductive connection structures 130 between a first and a second finger electrodes, there is no conductive connection structure 130 between the second and a third finger electrodes, and there is one or more conductive connection structures 130 between the third and a fourth finger electrodes, and so on. Alternatively, there is one or more conductive connection structures 130 between the first and the second finger electrodes, there is one or more conductive connection structures 130 between the second and the third finger electrodes, there is no conductive connection structure 130 between the third and the fourth finger electrodes, and there is one or more conductive connection structures 130 between the fourth and a fifth finger electrodes, and so on. Alternatively, the conductive connection structures 130 may be arranged in an irregular manner.

It is noted that the above-mentioned arrangement manners are only examples for ease of illustration, other arrangement manners also can be applied.

Referring to FIG. 3, in some embodiments, there are a plurality of conductive connection structures 130 arranged at intervals between adjacent finger electrodes 150. That is to say, there are a plurality of conductive connection structures 130 arranged at intervals along the second direction between adjacent finger electrodes 150. In this way, the transverse transferring capacity between adjacent finger electrodes 150 can be improved. Compared with the case where there is only one conductive connection structure 130 between adjacent finger electrodes 150, the more the conductive connection structures 130, the stronger the transverse transferring capacity is.

In some embodiments, in the second direction Y, a distance between adjacent conductive connection structures 130 of the plurality of conductive connection structures 130 arranged at intervals is constant. In this way, it is convenient to the laser ablation process in the generating process, in other word, there is no need of adjusting the distance between adjacent conductive connection structures, thereby being convenient to the production.

In some embodiments, a distance between adjacent conductive connection structures 130 in the second direction ranges from 0.01 mm to 20 mm, such as 0.1 mm, 0.5 mm, 10 mm or the like. When the distance between adjacent conductive connection structures 130 is less than 0.01 mm, excessively serried conductive connection structures 130 may cause serious light absorption, which is not conducive to improving the photoelectric conversion efficiency of the solar cell. When the distance between adjacent conductive connection structures 130 is greater than 20 mm, excessively few conductive connection structures 130 cannot provide improving effect good enough. In some other embodiments, the distance between adjacent conductive connection structures 130 may have other values, which may be determined according to actual situation, embodiments of the present disclosure do not limit the distance between adjacent conductive connection structures 130.

Referring to FIGS. 3, 6 and 7, in some embodiments, the plurality of conductive connection structures 130 form an array, and the array includes a plurality of columns of conductive connection structures 130 arranged along the first direction X and a plurality of rows of conductive connection structures 130 arranged along the second direction Y. In other words, the plurality of conductive connection structures 130 are arranged in a regular manner along the first direction X and the second direction Y. In this way, the transverse transferring capacity of the solar cell can be improved, and the production difficulty of forming the plurality of conductive connection structures 130 can be reduced.

Taking the solar cell including 4 columns of conductive connection structures 130 arranged along the first direction X as an example, a first, a second, a third and a fourth columns of conductive connection structures are arranged along the first direction X in sequence, and in the second direction Y, any conductive connection structure of the first column of conductive connection structures and a respective conductive connection structure of the second column of conductive connection structures, a respective conductive connection structure of the third column of conductive connection structures and a respective conductive connection structure of the fourth column of conductive connection structures are in a same row. In some other embodiments, any conductive connection structure of the first column of conductive connection structures and a respective conductive connection structure of the second column of conductive connection structures may be not in a same row. In other words, in the second direction, the first and second column of conductive connection structures are arranged in a stagger manner relative to each other. Alternatively, some conductive connection structures of the first column of conductive connection structures and respective conductive connection structures of the second column of conductive connection structures are respectively arranged in a same row. The present disclosure does not specifically limit the conductive connection structures 130, as long as the plurality of conductive connection structures 130 form an array.

In some embodiments, a width of the at least one conductive connection structure 130 in the second direction Y ranges from 10 µm to 500 µm, such as 50 µm, 80 µm, 100 µm or the like. It should be understood that when the width of the at least one conductive connection structure 130 is less than 10 µm, the transverse transferring capacity of each conductive connection structure 130 is weak, and the conductive connection structure cannot provide good improving effect. When the width of the at least one conductive connection structure 130 is greater than 500 µm, the conductive connection structure 130 may have a high-level parasitic absorption of light, which is detrimental to the improvement of photoelectric conversion efficiency of the solar cell. In some other embodiments, the width of the at least one conductive connection structure 130 may have other values, which may be determined according to actual situation.

In some embodiments, a top surface of the at least one conductive connection structure 130 is lower than or flush with a top surface of a protrusion 121. In other words, in a direction perpendicular to the surface of the substrate 100, a thickness of the at least one conductive connection structure 130 is less than or equal to a thickness of a protrusion 121. When the top surface of the conductive connection structure 130 is lower than the top surface of the protrusion 121, light-absorption capacity of the conductive connection structure 130 can be reduced, which is conducive to improving photoelectric conversion efficiency of the solar cell. When the top surface of the conductive connection structure 130 is flush with the top surface of the protrusion 121, the production process of the solar cell can be simplified, and the protrusions 121 and the at least one conductive connection structure 130 can be formed in a same process operation by laser ablation. In some other embodiments, the top surface of the conductive connection structure 130 may be higher than the top surface of the protrusion 121, which may be determined according to actual situation.

In some embodiments, in the direction perpendicular to the surface of the substrate 100, a height of the at least one conductive connection structure 130 may be 0.5 to 1.2 times of a height of a protrusion 121. When the height of the conductive connection structure 130 is less than 0.5 times of the height of the protrusion 121, the conductive connection structure 130 is relatively thin, which results in a relatively weak transverse transferring capacity and a not prominent improvement. When the height of the conductive connection structure 130 is greater than 1.2 times of the height of the protrusion 121, the conductive connection structure 130 is relatively thick, which results in a relatively strong capacity of parasitic absorption of light of the conductive connection structure 130 and therefore a reduction in the photoelectric conversion efficiency of the solar cell.

In some embodiments, the solar cell further includes at least one busbar 160 extending along the first direction X and electrically connected with the plurality of finger electrodes 150 arranged along the first direction X. Through the at least one busbar 160, the currents collected by the plurality of finger electrodes 150 can be converged and outputted from the solar cell.

In some embodiments, the plurality of conductive connection structures 130 are spaced from the at least one busbar 160. In this way, the at least one busbar 160 can be limited by the plurality of conductive connection structures 130, which is conducive to the subsequent printing of the at least one busbar 160. Moreover, the position of the at least one busbar 160 can be determined without additional positioning operation, which is conducive to the production operations.

In some embodiments, a column of conductive connection structures 130 arranged at intervals along the first direction X may be formed between adjacent busbars 160. In some other embodiments, more than one column of conductive connection structures 130 arranged at intervals along the first direction X may be formed between adjacent busbars 160. The present disclosure does not limit the number of the conductive connection structures 130 between adjacent busbars 160, which may be determined according to actual situation.

In some embodiments, projections of the plurality of conductive connection structures 130 on the substrate 100 are at least partially overlapped with a projection of the at least one busbar 160 on the substrate 100. The busbar 160 is generally of non-sintered type and used to collect the photo-generated carriers collected by the plurality of finger electrodes 150. That is to say, the busbar 160 will not corrode the structure under the busbar 160, so that the conductive connection structures 130 formed under the busbar 160 will not be affected by the busbar. Therefore, the transverse transferring capacity of the conductive connection structures 130 will not be affected. Moreover, the busbar 160 that at least shields a part of each conductive connection structures 130 can reduce capacity of parasitic absorption of light of the conductive connection structures 130, thereby improving the photoelectric conversion efficiency of the solar cell.

In some embodiments, the solar cell includes a plurality of busbars, and there are at least two columns of conductive connection structures 130 arranged along the first direction X on a side of a peripheral busbar 160 towards an edge of the substrate. In some other embodiments, no conductive connection structure or one column of conductive connection structures arranged along the first direction is formed on the side of the peripheral busbar towards the edge of the substrate. By forming at least two columns of conductive connection structures 130, the number of the conductive connection structures 130 can be increased, thereby improving the transverse transferring capacity of the solar cell.

In some embodiments, the solar cell has a front surface and a rear surface. The front surface is a light receiving surface that absorbs incident light, and the rear surface is a surface opposite to the front surface. The tunneling dielectric layer 110, the doped conductive layer 120, the at least one conductive connection structure 130, the passivation layer 140 and the plurality of finger electrodes 150 may be respectively formed over the front surface and the rear surface of the solar cell.

In some embodiments, a doped conductive layer 120 formed over the rear surface of the solar cell and the substrate 100 are of a same doping type, and a doped conductive layer 120 formed over the front surface of the solar cell and the substrate 100 are of different doping types. Taking the substrate 100 being an N-type substrate as an example, doping type of the doped conductive layer 120 formed over the rear surface of the solar cell is N type, and doping type of the doped conductive layer 120 formed over the front surface of the solar cell is P type.

In the embodiments of the present disclosure, the tunneling dielectric layer 110 and the doped conductive layer 120 are formed over the substrate 100, and the doped conductive layer 120 has a plurality of protrusions 121, thereby forming height differences on the doped conductive layer 120. In this way, contacts between the plurality of finger electrodes 150 and the doped conductive layer 120 can be ensured, and the parasitic absorption of light of the doped conductive layer 120 can be reduced. At least one conductive connection structure 130 is formed between adjacent protrusions 121 of the doped conductive layer 120, and the adjacent protrusions 121 are connected by the conductive connection structure 130. In this way, the transverse transferring capacity of the doped conductive layer 120 can be improved, thereby increasing the transfer rate of the solar cell.

Referring to FIG. 8, embodiments of the present disclosure provide a photovoltaic module configured to convert the received light energy into electrical energy and transfer it to external loads. The photovoltaic module includes at least one cell string 10, at least one encapsulation layer 21 and at least one cover plate 22. The at least one cell string 10 includes a plurality of solar cells as described above (such as, FIGS. 1 to 4), and the plurality of solar cells are electrically connected in sequence. The at least one encapsulation layer is configured to cover a surface of the at least one cell string. The at least one cover plate is configured to cover a surface of the at least one encapsulation layer 21 facing away from the at least one cell string.

The at least one encapsulation layer 21 may be an organic encapsulation adhesive film such as an ethylene vinyl acetate copolymer (EVA) adhesive film, or a polyethylene octene copolymer (POE) adhesive film. The encapsulation layer 21 covers a surface of the cell string to seal and protect the cell string. In some embodiments, the encapsulation layers 21 includes an upper encapsulation adhesive film and a lower encapsulation adhesive film that respectively cover an upper surface and a lower surface of the cell string. The at least one cover plate 22 may be a cover plate for protecting the cell string, such as a glass cover plate, a plastic cover plate or the like. The at least one cover plate 22 covers a surface of the encapsulation layer 21 facing away from the cell string. In some embodiments, the cover plate 22 has a light trapping structure to increase the utilization rate of the incident light. In this way, the photovoltaic module can have high current-collection capacity, low carrier recombination rate, and therefore high photoelectric conversion efficiency. In some embodiments, the cover plates 22 include an upper cover plate and a lower cover plate located on either sides of the cell string.

Those having ordinary skill in the art shall understand that the above embodiments are exemplary implementations for realizing the present disclosure. In practice, any person skilled in the art to which the embodiments of the present disclosure belong may make any modifications and changes in forms and details without departing from the scope of the present disclosure. Therefore, the patent scope of protection of the present disclosure shall still be subject to the scope limited by the appended claims.

## Claims

1. A solar cell, comprising:
a substrate (100) including a first surface and a second surface;
a passivation contact structure formed on the first surface of the substrate (100), including:
a tunneling dielectric layer (110) formed on the first surface; and
a doped silicon layer (120) formed on the tunneling dielectric layer (110), wherein the doped silicon layer (120) has a plurality of protrusions (121) arranged along a first direction (X), and each protrusion of the plurality of protrusions (121) extends along a second direction (Y) perpendicular to the first direction (X);
silicon connection structures (130) formed at intervals along the second direction (Y), each of the silicon connection structures (130) extending along the first direction (X), wherein at least one silicon connection structure of the silicon connection structures (130) is formed between two respective adjacent protrusions (121) of the plurality of protrusions (121) and is directly connected with sidewalls of the two respective protrusions (121);
an antireflection layer (140) formed over the doped silicon layer (120) and the silicon connection structures (130); and
a plurality of finger electrodes (150), wherein each finger electrode of the plurality of finger electrodes (150) extends along the second direction (Y) and penetrate the antireflection layer (140) to connect to a respective protrusion.

2. The solar cell according to claim 1, wherein a material of the antireflection layer (140) includes one or more of hydrogen-containing silicon oxide, hydrogen-containing silicon nitride, and hydrogen-containing silicon oxynitride.

3. The solar cell according to claim 2, wherein the silicon connection structures (130) form an array.

4. The solar cell according to any one of claims 1 to 3, wherein in a direction perpendicular to the first surface of the substrate (100), a ratio of a height of one respective silicon connection structure (130) of the silicon connection structures (130) to a height of one respective protrusion of the plurality of protrusions (121) ranges from 0.5 to 1.2.

5. The solar cell according to any one of claims 1 to 4, wherein there is at least one finger electrode (150) located between adjacent silicon connection structures (130) in the first direction (X).

6. The solar cell according to claim 3, wherein the array includes a plurality of columns of silicon connection structures (130) arranged along the first direction (X) and a plurality of rows of silicon connection structures (130) arranged along the second direction (Y).

7. The solar cell according to claim 6, wherein along the first direction (X), silicon connection structures (130) forming one respective column of the plurality of columns of silicon connection structures (130) and silicon connection structures (130) forming another column of the plurality of columns of silicon connection structures (130) adjacent to the one respective column are not arranged in a same row along the second direction (Y); and
along the second direction (Y), silicon connection structures (130) forming one respective row of the plurality of rows of silicon connection structures (130) and silicon connection structures (130) forming another row of the plurality of rows of silicon connection structures (130) adjacent to the one respective row are arranged in a stagger manner.

8. The solar cell according to any one of claims 1 to 7, further including at least one busbar (160) extending along the first direction (X) and electrically connected with the plurality of finger electrodes (150).

9. The solar cell according to claim 8, wherein projections of the silicon connection structures (130) on the substrate (100) are at least partially overlapped with a projection of the at least one busbar (160) on the substrate (100).

10. The solar cell according to any one of claims 1 to 9, wherein in a direction perpendicular to the first surface of the substrate (100), top surfaces of the silicon connection structures (130) are lower than or flush with a top surface of one respective protrusion of the plurality of protrusions (121).

11. The solar cell according to any one of claims 1 to 10, wherein the plurality of silicon connection structures and the doped silicon layer (120) are made of a same material.

12. A photovoltaic module, comprising:
at least one cell string including a plurality of solar cells (10) that are electrically connected;
at least one encapsulation layer (21) configured to cover a surface of the at least one cell string; and
at least one cover plate (22) configured to cover a surface of the at least one encapsulation layer (21) facing away from the at least one cell string;
wherein each solar cell of the plurality of solar cells (10) is the solar cell according to any one of claims 1 to 11.

## Patentansprüche

1. Solarzelle, umfassend:
ein Substrat (100) mit einer ersten Oberfläche und einer zweiten Oberfläche;
eine Passivierungskontaktstruktur, die auf der ersten Oberfläche des Substrats (100) ausgebildet ist, umfassend:
eine Tunneldielektrikumsschicht (110), die auf der ersten Oberfläche ausgebildet ist; und
eine dotierte Siliziumschicht (120), die auf der Tunneldielektrikumsschicht (110) ausgebildet ist, wobei die dotierte Siliziumschicht (120) eine Vielzahl von Vorsprüngen (121) aufweist, die entlang einer ersten Richtung (X) angeordnet sind, und wobei sich jeder Vorsprung der Vielzahl von Vorsprüngen (121) entlang einer zweiten Richtung (Y) senkrecht zur ersten Richtung (X) erstreckt;
Siliziumverbindungsstrukturen (130), die in Abständen entlang der zweiten Richtung (Y) ausgebildet sind, wobei sich jede der Siliziumverbindungsstrukturen (130) entlang der ersten Richtung (X) erstreckt, wobei mindestens eine Siliziumverbindungsstruktur der Siliziumverbindungsstrukturen (130) zwischen zwei jeweiligen benachbarten Vorsprüngen (121) der Vielzahl von Vorsprüngen (121) ausgebildet und direkt mit Seitenwänden der zwei jeweiligen Vorsprünge (121) verbunden ist;
eine Antireflexionsschicht (140), die über der dotierten Siliziumschicht (120) und den Siliziumverbindungsstrukturen (130) ausgebildet ist; und
eine Vielzahl von Fingerelektroden (150), wobei sich jede Fingerelektrode der Vielzahl von Fingerelektroden (150) entlang der zweiten Richtung (Y) erstreckt und die Antireflexionsschicht (140) durchdringt, um mit einem jeweiligen Vorsprung verbunden zu werden.

2. Solarzelle nach Anspruch 1, wobei ein Material der Antireflexionsschicht (140) eines oder mehrere von wasserstoffhaltigem Siliziumoxid, wasserstoffhaltigem Siliziumnitrid und wasserstoffhaltigem Siliziumoxynitrid umfasst.

3. Solarzelle nach Anspruch 2, wobei die Siliziumverbindungsstrukturen (130) eine Anordnung bilden.

4. Solarzelle nach einem der Ansprüche 1 bis 3, wobei in einer Richtung senkrecht zur ersten Oberfläche des Substrats (100) ein Verhältnis einer Höhe einer jeweiligen Siliziumverbindungsstruktur (130) der Siliziumverbindungsstrukturen (130) zu einer Höhe eines jeweiligen Vorsprungs der Vielzahl von Vorsprüngen (121) im Bereich von 0,5 bis 1,2 liegt.

5. Solarzelle nach einem der Ansprüche 1 bis 4, wobei mindestens eine Fingerelektrode (150) zwischen benachbarten Siliziumverbindungsstrukturen (130) in der ersten Richtung (X) angeordnet ist.

6. Solarzelle nach Anspruch 3, wobei die Anordnung eine Vielzahl von Spalten von Siliziumverbindungsstrukturen (130), die entlang der ersten Richtung (X) angeordnet sind, und eine Vielzahl von Reihen von Siliziumverbindungsstrukturen (130), die entlang der zweiten Richtung (Y) angeordnet sind, umfasst.

7. Solarzelle nach Anspruch 6, wobei entlang der ersten Richtung (X) Siliziumverbindungsstrukturen (130), die eine jeweilige Spalte der Vielzahl von Spalten von Siliziumverbindungsstrukturen (130) bilden, und Siliziumverbindungsstrukturen (130), die eine andere, der einen jeweiligen Spalte benachbarte Spalte der Vielzahl von Spalten von Siliziumverbindungsstrukturen (130) bilden, nicht in einer selben Reihe entlang der zweiten Richtung (Y) angeordnet sind; und
entlang der zweiten Richtung (Y) Siliziumverbindungsstrukturen (130), die eine jeweilige Reihe der Vielzahl von Reihen von Siliziumverbindungsstrukturen (130) bilden, und Siliziumverbindungsstrukturen (130), die eine andere, der einen jeweiligen Reihe benachbarte Reihe der Vielzahl von Reihen von Siliziumverbindungsstrukturen (130) bilden, versetzt angeordnet sind.

8. Solarzelle nach einem der Ansprüche 1 bis 7, ferner umfassend mindestens eine Sammelschiene (160), die sich entlang der ersten Richtung (X) erstreckt und elektrisch mit der Vielzahl von Fingerelektroden (150) verbunden ist.

9. Solarzelle nach Anspruch 8, wobei sich Projektionen der Siliziumverbindungsstrukturen (130) auf dem Substrat (100) zumindest teilweise mit einer Projektion der mindestens einen Sammelschiene (160) auf dem Substrat (100) überlappen.

10. Solarzelle nach einem der Ansprüche 1 bis 9, wobei in einer Richtung senkrecht zur ersten Oberfläche des Substrats (100) obere Flächen der Siliziumverbindungsstrukturen (130) niedriger als eine obere Fläche eines jeweiligen Vorsprungs der Vielzahl von Vorsprüngen (121) sind oder bündig mit dieser abschließen.

11. Solarzelle nach einem der Ansprüche 1 bis 10, wobei die Vielzahl von Siliziumverbindungsstrukturen und die dotierte Siliziumschicht (120) aus einem selben Material bestehen.

12. Fotovoltaisches Modul, umfassend:
mindestens einen Zellenstrang, der eine Vielzahl von Solarzellen (10) umfasst, die elektrisch verbunden sind;
mindestens eine Verkapselungsschicht (21), die dazu ausgebildet ist, eine Oberfläche des mindestens einen Zellenstrangs zu bedecken; und
mindestens eine Abdeckplatte (22), die dazu ausgebildet ist, eine Oberfläche der mindestens einen Verkapselungsschicht (21) zu bedecken, die von dem mindestens einen Zellenstrang abgewandt ist;
wobei jede Solarzelle der Vielzahl von Solarzellen (10) die Solarzelle nach einem der Ansprüche 1 bis 11 ist.

## Revendications

1. Cellule solaire, comprenant :
un substrat (100) comprenant une première surface et une deuxième surface ;
une structure de contact de passivation formée sur la première surface du substrat (100), comprenant :
une couche diélectrique tunnel (110) formée sur la première surface ; et
une couche de silicium dopé (120) formée sur la couche diélectrique tunnel (110), dans laquelle la couche de silicium dopé (120) présente une pluralité de saillies (121) agencées selon une première direction (X), et chaque saillie de la pluralité de saillies (121) s'étend selon une deuxième direction (Y) perpendiculaire à la première direction (X) ;
des structures de connexion en silicium (130) formées à intervalles selon la deuxième direction (Y), chacune des structures de connexion en silicium (130) s'étendant selon la première direction (X), dans laquelle au moins une structure de connexion en silicium des structures de connexion en silicium (130) est formée entre deux saillies adjacentes respectives (121) de la pluralité de saillies (121) et est directement reliée à des parois latérales des deux saillies respectives (121) ;
une couche antireflet (140) formée sur la couche de silicium dopé (120) et les structures de connexion en silicium (130) ; et
une pluralité d'électrodes en forme de doigt (150), dans laquelle chaque électrode en forme de doigt de la pluralité d'électrodes en forme de doigt (150) s'étend selon la deuxième direction (Y) et pénètre la couche antireflet (140) pour se connecter à une saillie respective.

2. Cellule solaire selon la revendication 1, dans laquelle un matériau de la couche antireflet (140) comprend un ou plusieurs parmi l'oxyde de silicium contenant de l'hydrogène, le nitrure de silicium contenant de l'hydrogène et l'oxynitrure de silicium contenant de l'hydrogène.

3. Cellule solaire selon la revendication 2, dans laquelle les structures de connexion en silicium (130) forment un réseau.

4. Cellule solaire selon l'une quelconque des revendications 1 à 3, dans laquelle, selon une direction perpendiculaire à la première surface du substrat (100), un rapport d'une hauteur d'une structure de connexion en silicium respective (130) des structures de connexion en silicium (130) à une hauteur d'une saillie respective de la pluralité de saillies (121) est compris entre 0,5 et 1,2.

5. Cellule solaire selon l'une quelconque des revendications 1 à 4, dans laquelle au moins une électrode en forme de doigt (150) est située entre des structures de connexion en silicium adjacentes (130) selon la première direction (X).

6. Cellule solaire selon la revendication 3, dans laquelle le réseau comprend une pluralité de colonnes de structures de connexion en silicium (130) agencées selon la première direction (X) et une pluralité de rangées de structures de connexion en silicium (130) agencées selon la deuxième direction (Y).

7. Cellule solaire selon la revendication 6, dans laquelle, selon la première direction (X), des structures de connexion en silicium (130) formant une colonne respective de la pluralité de colonnes de structures de connexion en silicium (130) et des structures de connexion en silicium (130) formant une autre colonne de la pluralité de colonnes de structures de connexion en silicium (130) adjacente à ladite colonne respective ne sont pas agencées dans une même rangée selon la deuxième direction (Y) ; et
selon la deuxième direction (Y), des structures de connexion en silicium (130) formant une rangée respective de la pluralité de rangées de structures de connexion en silicium (130) et des structures de connexion en silicium (130) formant une autre rangée de la pluralité de rangées de structures de connexion en silicium (130) adjacente à ladite rangée respective sont agencées de manière décalée.

8. Cellule solaire selon l'une quelconque des revendications 1 à 7, comprenant en outre au moins une barre omnibus (160) s'étendant selon la première direction (X) et électriquement reliée à la pluralité d'électrodes en forme de doigt (150).

9. Cellule solaire selon la revendication 8, dans laquelle des projections des structures de connexion en silicium (130) sur le substrat (100) chevauchent au moins partiellement une projection de l'au moins une barre omnibus (160) sur le substrat (100).

10. Cellule solaire selon l'une quelconque des revendications 1 à 9, dans laquelle, selon une direction perpendiculaire à la première surface du substrat (100), des surfaces supérieures des structures de connexion en silicium (130) sont plus basses qu'une surface supérieure d'une saillie respective de la pluralité de saillies (121) ou affleurent celle-ci.

11. Cellule solaire selon l'une quelconque des revendications 1 à 10, dans laquelle la pluralité de structures de connexion en silicium et la couche de silicium dopé (120) sont constituées d'un même matériau.

12. Module photovoltaïque, comprenant :
au moins une chaîne de cellules comprenant une pluralité de cellules solaires (10) qui sont électriquement reliées ;
au moins une couche d'encapsulation (21) configurée pour recouvrir une surface de l'au moins une chaîne de cellules ; et
au moins une plaque de couverture (22) configurée pour recouvrir une surface de l'au moins une couche d'encapsulation (21) opposée à l'au moins une chaîne de cellules ;
dans lequel chaque cellule solaire de la pluralité de cellules solaires (10) est la cellule solaire selon l'une quelconque des revendications 1 à 11.
